# EUROPEAN PATENT APPLICATION

(11) **EP 4 664 518 A2**
(43) Date of publication of application: **17.12.2025**
(21) Application number: 25209959.3
(22) Date of filing: 21.10.2025
(51) Int. Cl.: H01L 23/367, H01L 23/42

(54) **CHIP PACKAGING STRUCTURE AND DOMAIN CONTROLLER**

(30) Priority: 09.12.2024 CN 202411812384
(71) Applicant: Horizon Journey (Shanghai) Technology Co., Ltd., Shanghai 201306 (CN)
(72) Inventor: GUO, Mao, Shanghai, 201306 (CN); ZHANG, Min, Shanghai, 201306 (CN)
(74) Representative: Patentanwälte Magenbauer & Kollegen Partnerschaft mbB

(57) **Abstract**

Disclosed are a chip packaging structure and a domain controller, including: a heat-generating chip; a substrate, the substrate carrying the heat-generating chip; a heat dissipating cover covering the substrate to form an accommodating space for the heat-generating chip enclosed by the substrate, an inner bottom wall of the heat dissipating cover, and an inner side wall of the heat dissipating cover; a thermal conductive medium provided between a first surface of the heat-generating chip and a first region of an inner bottom wall; and a reinforcing structure abutting against a second region of the inner bottom wall other than the first region and an inner side wall, wherein a second surface of the reinforcing structure facing the heat-generating chip meets that: the closer a part of the second surface is to the inner side wall, the further it is away from the second region in distance, and vice versa.

## Description

### FIELD OF THE INVENTION

This disclosure relates to the technical field of chips, and in particular, to a chip packaging structure and a domain controller.

### BACKGROUND OF THE INVENTION

Presently, a chip packaging structure is applied widely. A chip packaging structure may be of a type such as a flip chip ball grid array (FCBGA). In related art, a chip packaging structure is of poor heat dissipation performance. A noteworthy problem for those skilled in the art is how to improve heat dissipation performance of a chip packaging structure.

### SUMMARY OF THE INVENTION

To solve the foregoing technical problem, this disclosure provides a chip packaging structure and a domain controller.

According to an aspect of embodiments of this disclosure, a chip packaging structure is provided, and includes:
a heat-generating chip;
a substrate, the substrate carrying the heat-generating chip;
a heat dissipating cover, the heat dissipating cover covering the substrate such that the heat-generating chip is located within an accommodating space enclosed by the substrate, an inner bottom wall of the heat dissipating cover, and an inner side wall of the heat dissipating cover;
a thermal conductive medium, the thermal conductive medium being provided between a first surface of the heat-generating chip facing away from the substrate and a first region of the inner bottom wall; and
a reinforcing structure, the reinforcing structure abutting against a second region of the inner bottom wall other than the first region, the reinforcing structure further abutting against the inner side wall, wherein a second surface of the reinforcing structure facing the heat-generating chip meets that: the closer a part of the second surface is to the inner side wall, the further it is away from the second region in distance, and the further the part is away from the inner side wall, the closer it is to the second region in distance.

According to another aspect of embodiments of this disclosure, a domain controller is provided, and includes the chip packaging structure.

Based on the chip packaging structure and the domain controller provided by the foregoing embodiments of this disclosure, the substrate may carry the heat-generating chip. The heat dissipating cover may cover the substrate, to package the heat-generating chip in the accommodating space enclosed by the substrate, the inner bottom wall of the heat dissipating cover, and the inner side wall of the heat dissipating cover. As the thermal conductive medium is provided between the first surface of the heat-generating chip facing away from the substrate and the first region of the inner bottom wall of the heat dissipating cover, through a heat conduction effect served by the thermal conductive medium, heat produced by the heat-generating chip may be conducted rapidly to the heat dissipating cover through the thermal conductive medium to dissipate. As the reinforcing structure is provided against both the second region of the inner bottom wall of the heat dissipating cover and the inner side wall of the heat dissipating cover, and the second surface of the reinforcing structure facing the heat-generating chip meets the target condition, this facilitates forming of a triangular stable structure or a triangle-like stable structure within the accommodating space, thereby improving the stiffness of the heat dissipating cover and even the whole chip packaging structure. Hot reflux processing often is to be performed on a chip packaging structure applying to a domain controller in a packaging process. After packaging is done, a series of stress tests often are to be performed on the chip packaging structure. Note that the heat-generating chip and the substrate are made of materials with usually nonmatching coefficients of thermal expansion. If the chip packaging structure is of insufficient stiffness, after hot reflux processing has been performed on the chip packaging structure, the substrate is extremely susceptible to warpage, which may cause separation of the heat dissipating cover and the thermal conductive medium, impacting the efficiency of heat conduction, thereby reducing the heat dissipation performance of the chip packaging structure. In addition, during a stress test, a fixture configured to implement the stress test may apply a stress on the heat dissipating cover, such that both the heat dissipating cover and the thermal conductive medium undergo deformation. The heat dissipating cover and the thermal conductive medium may differ in their abilities to recover from a deformation after the stress has been removed, which also may cause separation of the heat dissipating cover and the thermal conductive medium, impacting the efficiency of heat conduction, thereby reducing the heat dissipation performance of the chip packaging structure. In embodiments of this disclosure, providing the reinforcing structure allows to improve the stiffness of the heat dissipating cover and even the whole chip packaging structure, which not only facilitates reducing warpage of the substrate due to hot reflux processing, but also facilitates reducing amounts of deformation from which the heat dissipating cover and the thermal conductive medium are to recover after the stress has been taken off, thereby mitigating a degree of separation of the heat dissipating cover and the thermal conductive medium, guaranteeing the efficiency of heat conduction, guaranteeing the heat dissipation performance of the chip packaging structure.

### BRIEF DESCRIPTION OF THE DRAWINGS

FIG. 1 is a schematic diagram of a structure of a chip packaging structure according to some illustrative embodiments of this disclosure.
FIG. 2 is a schematic diagram of a structure of a chip packaging structure according to some other illustrative embodiments of this disclosure.
FIG. 3 is a schematic diagram of a structure of a chip packaging structure according to yet some other illustrative embodiments of this disclosure.
FIG. 4 is a schematic diagram of a structure of a chip packaging structure according to still some other illustrative embodiments of this disclosure.
FIG. 5 is a schematic diagram of composition of an inner bottom wall of a heat dissipating cover in some illustrative embodiments of this disclosure.
FIG. 6 is a schematic diagram of a reinforcing structure in some illustrative embodiments of this disclosure.
FIG. 7 is a schematic diagram of a structure of a chip packaging structure according to still some other illustrative embodiments of this disclosure.
FIG. 8-1 is a schematic diagram of a layout of a plurality of reinforcing structures in some illustrative embodiments of this disclosure.
FIG. 8-2 is a schematic diagram of a layout of a plurality of reinforcing structures in some other illustrative embodiments of this disclosure.
FIG. 9 is a schematic diagram of a result of finite element simulation in some illustrative embodiments of this disclosure.

### DETAILED DESCRIPTION OF THE EMBODIMENTS

Illustrative embodiments according to this disclosure are elaborated below with reference to the accompanying drawings. Clearly, the embodiments described are merely some embodiments of this disclosure, rather than all embodiments of this disclosure. It should be understood that this disclosure is not limited to the illustrative embodiments described here.

In description of this disclosure, an orientational or locational relation indicated by a term such as "upper", " lower", "left", "right", etc., is based on an orientational or locational relation shown in the accompanying drawings, is merely for ease of describing this disclosure and simplifying description, rather than indicating or implying that an apparatus under consideration must have a specific orientation and/or be constructed and operated in a specific orientation, and therefore cannot be understood as a limitation to this disclosure.

In description of this disclosure, unless explicitly specified and defined otherwise, a term such as "installing", "connecting", "fixing", etc., should be understood broadly, such as to be a fixed connection, a detachable connection, or a one-piece connection; a mechanical connection, or an electrical connection; and a direct connection, or an indirect connection through an intermediate medium. Those skilled in the art may understand a specific meaning of a foregoing term in this disclosure according to a specific case.

Embodiments of this disclosure provide a chip packaging structure.

Optionally, the chip packaging structure may apply to a domain controller. Understandably, the domain controller is a core component implementing a technology such as assisted driving, unmanned driving, etc., in a vehicle. The domain controller is a highly integrated complex circuit system. For example, the domain controller may be a circuit system integrated with a power supply module, a control module, a sensor module, an electronic control unit, etc.

Of course, when needed, the chip packaging structure may also apply to an apparatus or system other than a domain controller, which is not limited in this disclosure. For ease of understanding, description is made hereinafter taking a case of applying a chip packaging structure to a domain controller as an example.

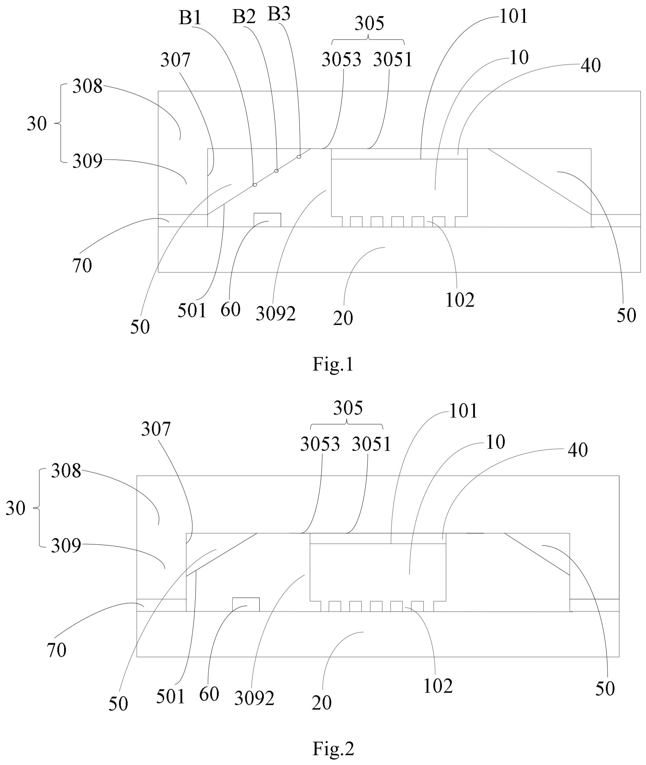

As shown in FIG. 1 to FIG. 4, a chip packaging structure includes:
a heat-generating chip 10;
a substrate 20, the substrate 20 carrying the heat-generating chip 10;
a heat dissipating cover 30, the heat dissipating cover 30 covering the substrate 20 such that the heat-generating chip 10 is located within an accommodating space enclosed by the substrate 20, an inner bottom wall 305 of the heat dissipating cover 30, and an inner side wall 307 of the heat dissipating cover 30;
a thermal conductive medium 40, the thermal conductive medium 40 being provided between a first surface 101 of the heat-generating chip 10 facing away from the substrate 20 and a first region 3051 of the inner bottom wall 305; and
a reinforcing structure 50. The reinforcing structure 50 is provided against a second region 3053 of the inner bottom wall 305 other than the first region 3051. The reinforcing structure 50 further is provided against the inner side wall 307. A target condition is met, i.e., of a second surface 501 of the reinforcing structure 50 facing the heat-generating chip 10, the closer a part of the second surface is to the inner side wall 307, the further it is away from the second region 3053 in distance, and the further the part is away from the inner side wall 307, the closer it is to the second region 3053 in distance.

Optionally, the heat-generating chip 10 may be a chip that may produce a lot of heat during operation. For example, the heat-generating chip 10 may be an intelligent driving chip.

Optionally, the substrate 20 may be a support for installing a component, and may also be referred to as a component carrier. A component mentioned here may include but is not limited to the heat-generating chip 10, an electronic component 60 mentioned below, etc. The substrate 20 may bear the heat-generating chip 10 at a top surface of the substrate. The heat-generating chip 10 may be fixed to the substrate 20. For example, a lower end of the heat-generating chip 10 may be provided with a number of micro bumps 102. The micro bumps 102 may be welded to the substrate 20, to fix the heat-generating chip 10 onto the substrate 20.

Optionally, the heat dissipating cover 30 may be a cover structure functioning to conduct heat, for support, and to assist in forming the accommodating space. The heat dissipating cover 30 may include:
a heat spreader 308, the heat spreader 308 including an upper surface and a lower surface provided in parallel; and
a base 309. The base 309 may extend from the lower surface of the heat spreader 308 in a direction away from the upper surface of the heat spreader 308. The base 309 may have a central through hole 3092. The central through hole 3092 may be a square hole. A hole bottom wall of the central through hole 3092 and the lower surface of the heat spreader 308 are flush.

In case the heat dissipating cover 30 is composed of a foregoing structure, the hole bottom wall of the central through hole 3092 may serve as the inner bottom wall 305 of the heat dissipating cover 30, and a hole side wall of the central through hole 3092 may serve as the inner side wall 307 of the heat dissipating cover 30. The heat spreader 308, the base 309, and the substrate 20 may be provided in a centered fashion. A lower surface of the base 309 may be bonded to an upper surface of the substrate 20 through the adhesive 70, such that the heat dissipating cover 30 covers the substrate 20. Accordingly, the substrate 20, the inner bottom wall 305 of the heat dissipating cover 30, and the inner side wall 307 of the heat dissipating cover 30 may enclose the accommodating space, for accommodating the heat-generating chip 10.

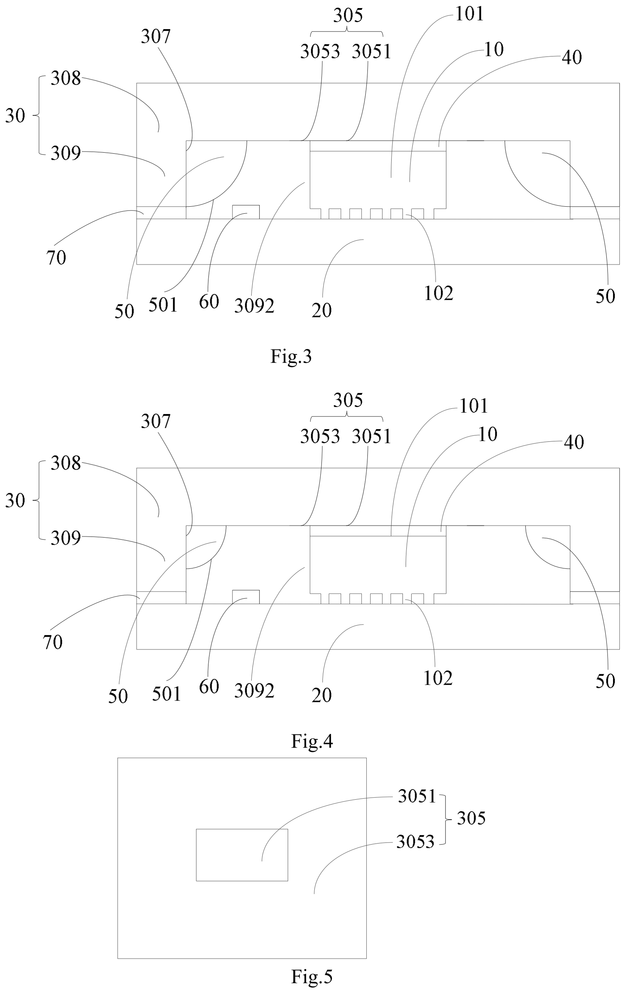

Optionally, the thermal conductive medium 40 may be a medium of good heat-conducting performance. The thermal conductive medium 40 may also be referred to as a thermal interface material. The thermal conductive medium 40 may include but is not limited to silicone gel, thermal conductive silicone grease, thermal conductive gel, etc. The thermal conductive medium 40 may be provided between the first surface 101 of the heat-generating chip 10 facing away from the substrate 20 and the first region 3051 of the inner bottom wall 305. The first surface 101 of the heat-generating chip 10 facing away from the substrate 20 may be the upper surface of the heat-generating chip 10. The first region 3051 of the inner bottom wall 305 of the heat dissipating cover 30 may be a projection region, of the inner bottom wall 305 of the heat dissipating cover 30, onto which the heat-generating chip 10 is projected. The projection region may be a rectangular region. A remaining region of the inner bottom wall 305 of the heat dissipating cover 30 other than the first region 3051 may be collectively referred to as the second region 3053. Specifically, one may refer to FIG. 5 for composition of the inner bottom wall 305 of the heat dissipating cover 30.

Optionally, the reinforcing structure 50 may be a structure capable of improving stiffness of the heat dissipating cover 30 and even the whole chip packaging structure. The reinforcing structure 50 may include the second surface 501 facing the heat-generating chip 10. The second surface 501 may be a flat surface or a curved surface. The curved surface may be a convex surface or a concave surface. A remaining part of the reinforcing structure 50 other than the second surface 501 may be located in a space defined by the second region 3053, the inner side wall 307, and the second surface 501. The second surface 501 may meet the aforementioned target condition. For example, as shown in FIG. 1, the second surface 501 may include a part B1, a part B2, and a part B3. The part B1 may be the closest to the inner side wall 307. The part B3 may be the furthest away from the inner side wall 307. Then, the part B1 may be the furthest away from the second region 3053 in distance, the part B2 be the second furthest away from the second region 3053 in distance, and the part B3 be the closest to the second region 3053 in distance.

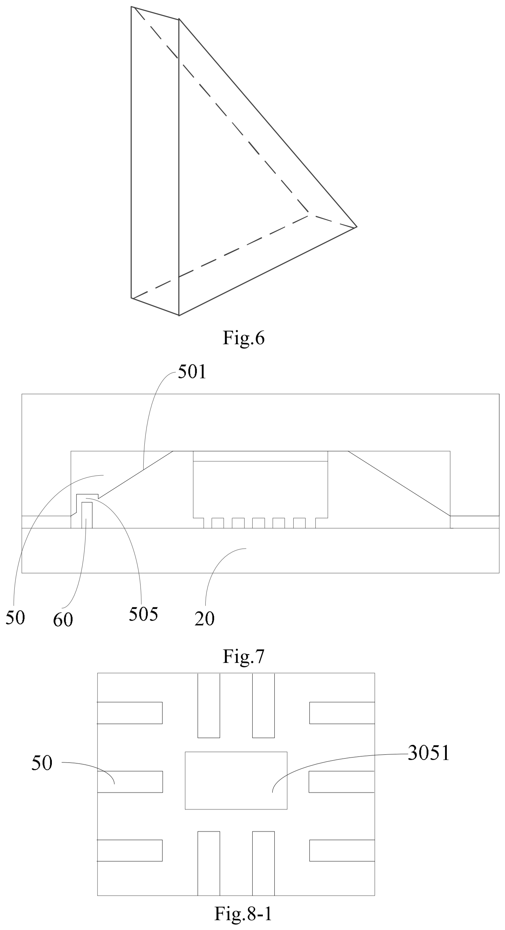

In an example, the reinforcing structure 50 may be a solid structure. The reinforcing structure 50 may be a reinforcement of a pentahedron structure similar to that shown in FIG. 6. One perpendicular edge of the reinforcement may be provided against the second region 3053. The other perpendicular edge of the reinforcement may be provided against the inner side wall 307. An outer surface of the diagonal edge of the reinforcement may serve as the second surface 501.

In another example, the reinforcing structure 50 may be a hollow structure. The reinforcing structure 50 may be a reinforcing plate placed at an angle. One end of the reinforcing plate may be provided against the second region 3053. The other end of the reinforcing plate may be provided against the inner side wall 307. An outer surface of the reinforcing plate may serve as the second surface 501.

In embodiments of this disclosure, the substrate 20 may bear the heat-generating chip 10. The heat dissipating cover 30 may cover the substrate 20, to package the heat-generating chip 10 in the accommodating space enclosed by the substrate 20, the inner bottom wall 305 of the heat dissipating cover 30, and the inner side wall 307 of the heat dissipating cover 30. As the thermal conductive medium 40 is provided between the first surface 101 of the heat-generating chip 10 facing away from the substrate 20 and the first region 3051 of the inner bottom wall 305 of the heat dissipating cover 30, through a heat conduction effect served by the thermal conductive medium 40, heat produced by the heat-generating chip 10 may be conducted rapidly to the heat dissipating cover 30 through the thermal conductive medium 40 to dissipate. For example, after being conducted to the heat dissipating cover 30, heat may further be conducted to a heat sink (such as a fin-type heat sink) in contact with an outer wall of the heat dissipating cover 30, and then dissipates into an external environment through the heat sink. As the reinforcing structure 50 is provided against both the second region 3053 of the inner bottom wall 305 of the heat dissipating cover 30 and the inner side wall 307 of the heat dissipating cover 30, and the second surface 501 of the reinforcing structure 50 facing the heat-generating chip 10 meets the target condition, this facilitates forming of a triangular stable structure (refer to FIG. 1 and FIG. 2) or a triangle-like stable structure (refer to FIG. 3 and FIG. 4) within the accommodating space, thereby improving the stiffness of the heat dissipating cover 30 and even the whole chip packaging structure.

Hot reflux processing (such as hot reflux processing with a temperature as high as 260 degrees Celsius) often is to be performed on a chip packaging structure applying to a domain controller in a packaging process. After packaging is done, a series of stress tests (such as burn in, final test, system level test, etc.) often are to be performed on the chip packaging structure. Note that the heat-generating chip 10 and the substrate 20 are made of materials with usually nonmatching coefficients of thermal expansion. If the chip packaging structure is of insufficient stiffness, after hot reflux processing has been performed on the chip packaging structure, the substrate 20 is extremely susceptible to warpage, which may cause separation of the heat dissipating cover 30 and the thermal conductive medium 40, impacting the efficiency of heat conduction, thereby reducing the heat dissipation performance of the chip packaging structure. In addition, during a stress test, a fixture configured to implement the stress test may apply a stress on the heat dissipating cover 30, such that both the heat dissipating cover 30 and the thermal conductive medium 40 undergo deformation. The heat dissipating cover 30 and the thermal conductive medium 40 may differ in their abilities to recover from a deformation after the stress has been removed, which also may cause separation of the heat dissipating cover 30 and the thermal conductive medium 40, impacting the efficiency of heat conduction, thereby reducing the heat dissipation performance of the chip packaging structure. In embodiments of this disclosure, providing the reinforcing structure 50 allows to improve the stiffness of the heat dissipating cover 30 and even the whole chip packaging structure, which not only facilitates reducing warpage of the substrate 20 due to hot reflux processing, but also facilitates reducing amounts of deformation from which the heat dissipating cover 30 and the thermal conductive medium 40 are to recover after the stress has been taken off, thereby mitigating a degree of separation of the heat dissipating cover 30 and the thermal conductive medium 40, guaranteeing the efficiency of heat conduction, guaranteeing the heat dissipation performance of the chip packaging structure.

In some optional examples, as shown in FIG. 1 to FIG. 4, the chip packaging structure further includes:
an electronic component 60. The substrate 20 may bear the electronic component 60. There may be a gap between the electronic component 60 and the reinforcing structure 50.

Optionally, the electronic component 60 may include but is not limited to a resistor, a capacitor, an inductor, a diode, a triode, etc., which are not listed one by one here. There may be two, three, four, or more, electronic components 60, which numbers are not listed one by one here. For ease of understanding, further introduction is made hereinafter for a single electronic component 60.

Optionally, the substrate 20 may bear the electronic component 60 at the top surface of the substrate. The electronic component 60 may be fixed to the substrate 20. For example, the electronic component 60 may be fixed to the substrate 20 by welding.

In embodiments of this disclosure, there is a gap between the electronic component 60 carried on the substrate 20 and the reinforcing structure 50. That is, the electronic component 60 is not in direct contact with the reinforcing structure 50, which allows the reinforcing structure 50 to shun the electronic component 60, to prevent the reinforcing structure 50 from impacting the electronic component 60, which facilitates guaranteeing normal and reliable operation of the electronic component 60 and even the whole chip packaging structure.

In some optional examples, as shown in FIG. 1 and FIG. 2, the second surface 501 is a flat surface. A slope of the flat surface may be adapted to a structural parameter of the electronic component 60 and a layout of the electronic component 60 with respect to the substrate 20, to allow the gap between the electronic component 60 and the reinforcing structure 50.

Optionally, the structural parameter of the electronic component 60 may include but is not limited to a shape parameter, a size parameter, etc., of the electronic component 60. The shape parameter may be configured to represent that the electronic component 60 is of a cylinder shape, a cuboid shape, a flake shape, etc., which are not listed one by one here. If the shape parameter is configured to represent that the electronic component 60 is of the cylinder shape, the size parameter may include a diameter and a height. If the shape parameter is configured to represent that the electronic component 60 is of the cuboid shape, the size parameter may include a length, a width, and a height.

Optionally, the layout of the electronic component 60 with respect to the substrate 20 may be configured to represent a providing location at which the electronic component 60 is provided on the substrate 20. As an example, the providing location may be represented using a two-dimensional coordinate.

Note that if the second surface 501 is a flat surface, the structural parameter of the electronic component 60 is fixed, and the layout of the electronic component 60 with respect to the substrate 20 is fixed, a space between the second surface 501 and the electronic component 60 may differ in size in case the slope of the second surface 501 differs. If the second surface 501 is a flat surface, the slope of the second surface 501 is fixed, and the structural parameter of the electronic component 60 is fixed, the space between the second surface 501 and the electronic component 60 may differ in size in case the layout of the electronic component 60 with respect to the substrate 20 differs (such as in case the electronic component 60 is moved horizontally to the left or to the right). If the second surface 501 is a flat surface, the slope of the second surface 501 is fixed, and the layout of the electronic component 60 with respect to the substrate 20 is fixed, the size of the space between the second surface 501 and the electronic component 60 may differ in case the structural parameters of the electronic component 60 vary (such as when the height is doubled or is halved).

It may be known from discussion in the last paragraph that in case the second surface 501 is a flat surface, the slope of second surface 501, the structural parameter of the electronic component 60, and the layout of the electronic component 60 with respect to the substrate 20 each may impact the size of the space between the second surface 501 and the electronic component 60. In view of this, the slope of the second surface 501 may be set to be adapted to both the structural parameters of the electronic component 60 and the layout of the electronic component 60 with respect to the substrate 20, such that a certain gap, rather than occurrence of any contact, between the reinforcing structure 50 and the electronic component 60, is ensured. In this way, the reinforcing structure 50 may shun the electronic component 60 effectively, which facilitates guaranteeing normal and reliable operation of the electronic component 60 and even the whole chip packaging structure.

In some optional examples, as shown in FIG. 3 and FIG. 4, the second surface 501 is a curved surface, and a curvature of the curved surface is adapted to a structural parameter of the electronic component 60 and a layout of the electronic component 60 with respect to the substrate 20, to allow the gap between the electronic component 60 and the reinforcing structure 50.

Optionally, refer to aforementioned related introduction for the structural parameter of the electronic component 60 and the layout of the electronic component 60 with respect to the substrate 20, which are not repeated here.

Note that if the second surface 501 is a curved surface, the structural parameter of the electronic component 60 is fixed, and the layout of the electronic component 60 with respect to the substrate 20 is fixed, a space between the second surface 501 and the electronic component 60 may differ in size in case the curvature of the second surface 501 differs. If the second surface 501 is a curved surface, the curvature of the second surface 501 is fixed, and the structural parameter of the electronic component 60 is fixed, the space between the second surface 501 and the electronic component 60 may differ in size in case the layout of the electronic component 60 with respect to the substrate 20 differs (such as in case the electronic component 60 is moved horizontally to the left or to the right). If the second surface 501 is a curved surface, the curvature of the second surface 501 is fixed, and the layout of the electronic component 60 with respect to the substrate 20 is fixed, the space between the second surface 501 and the electronic component 60 may differ in size in case the structural parameter of the electronic component 60 differs (such as when the height is doubled or is halved).

It may be known from discussion in the last paragraph that in case the second surface 501 is a curved surface, the curvature of the second surface 501, the structural parameter of the electronic component 60, and the layout of the electronic component 60 with respect to the substrate 20 each may impact the size of the space between the second surface 501 and the electronic component 60. In view of this, the curvature of the second surface 501 may be set to be adapted to both the structural parameter of the electronic component 60 and the layout of the electronic component 60 with respect to the substrate 20, such that a certain gap, rather than occurrence of any contact, between the reinforcing structure 50 and the electronic component 60, is ensured. In this way, the reinforcing structure 50 may shun the electronic component 60 effectively, which facilitates guaranteeing normal and reliable operation of the electronic component 60 and even the whole chip packaging structure.

In some optional examples, as shown in FIG. 7, the reinforcing structure 50 is a solid structure, the reinforcing structure 50 is provided with a weight reducing groove 505 having a notch located at the second surface 501, the weight reducing groove 505 is provided on the reinforcing structure 50 at a providing location corresponding to a providing location at which the electronic component 60 is provided on the substrate 20, and a portion of the electronic component 60 extends into the weight reducing groove 505, and leaves a gap between the portion extending into the weight reducing groove 505 and an inner wall of the weight reducing groove 505.

Optionally, by saying that the weight reducing groove 505 is provided on the reinforcing structure 50 at a providing location corresponding to a providing location at which the electronic component 60 is provided on the substrate 20, the following may be understood. If the providing location of the weight reducing groove 505 on the reinforcing structure 50 is projected onto the upper surface of the substrate 20, to obtain a projection location, the projection location may be the same, or essentially the same, as the providing location at which the electronic component 60 is provided on the substrate 20.

In embodiments of this disclosure, in case the reinforcing structure 50 is a solid structure, providing the weight reducing groove 505 allows to reduce a weight of the chip packaging structure while guaranteeing overall stiffness of the chip packaging structure. In addition, a portion of the electronic component 60 may extend into the weight reducing groove 505, and leaves a gap between the portion extending into the weight reducing groove 505 and an inner wall of the weight reducing groove 505, thus on one hand allowing to accommodate the electronic component 60, and on the other hand ensuring a certain gap between the reinforcing structure 50 and the electronic component 60. Therefore, with embodiments of this disclosure, reusing the weight reducing groove 505 allows the reinforcing structure 50 to shun the electronic component 60 effectively, which facilitates guaranteeing normal and reliable operation of the electronic component 60 and even the whole chip packaging structure.

In some optional examples, as shown in FIG. 1 to FIG. 4, there is a gap between the reinforcing structure 50 and the thermal conductive medium 40, and there is a gap between the reinforcing structure 50 and the heat-generating chip 10.

Note that a size of the gap between the reinforcing structure 50 and the thermal conductive medium 40, and a size of the gap between the reinforcing structure 50 and the heat-generating chip 10 may be set as needed while guaranteeing the stiffness of the chip packaging structure, which is not limited in this disclosure.

In embodiments of this disclosure, a certain gap, rather than occurrence of any direct contact, between the reinforcing structure 50 and the thermal conductive medium 40, may be ensured. Similarly, a certain gap, rather than occurrence of any direct contact, between the reinforcing structure 50 and the heat-generating chip 10, may also be ensured. In this way, a force applied at the reinforcing structure 50 will not be passed on to the thermal conductive medium 40 and the heat-generating chip 10, which facilitates avoiding separation of the thermal conductive medium 40 and the heat-generating chip 10 due to the force applied, thereby allowing to guarantee the heat dissipation performance of the chip packaging structure.

In some optional examples, the height of projection of the reinforcing structure 50 onto the inner side wall 307 is less than or equal to the height of the inner side wall 307.

Optionally, the heat dissipating cover 30 may include the heat spreader 308 and the base 309. The height of the inner side wall 307 may be understood as a protruding height by which the base 309 protrudes with respect to the heat spreader 308.

As shown in FIG. 1 and FIG. 3, the height of the projection of the reinforcing structure 50 onto the inner side wall 307 may be equal to the height of the inner side wall 307. In this way, it may be deemed that the reinforcing structure 50 is connected to the lower surface of the base 309, and the reinforcing structure 50 is allowed a maximal size as possible, which facilitates guaranteeing the stiffness of the chip packaging structure.

As shown in FIG. 2 and FIG. 4, The height of the projection of the reinforcing structure 50 onto the inner side wall 307 may be less than the height of the inner side wall 307. In this way, it may be deemed that the reinforcing structure 50 is not connected to the lower surface of the base 309, and the reinforcing structure 50 is less than the case shown in FIG. 1 and FIG. 3 in size, which allows more space to be left between the reinforcing structure 50 and the substrate 20, which facilitates shunning the electronic component 60 by the reinforcing structure 50.

In some optional examples, a plurality of the reinforcing structure 50 are provided, and the plurality of reinforcing structures 50 are symmetrically distributed with respect to the first region 3051.

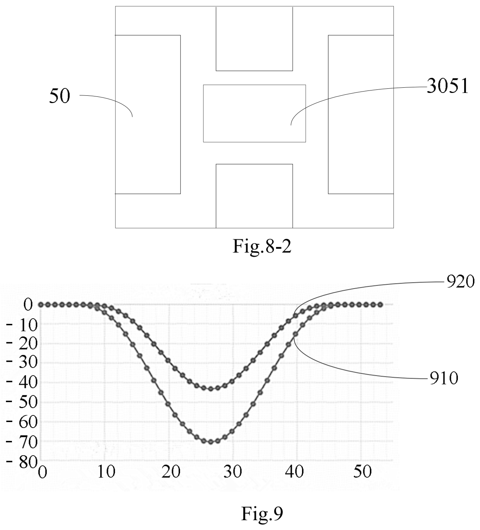

Optionally, if the reinforcing structure 50 is a solid structure, as shown in FIG. 8-1, one or more reinforcing structures 50 may be distributed in front of, behind, to the left of, and to the right of, the first region 3051, respectively. If the reinforcing structure 50 is a hollow structure, as shown in FIG. 8-2, one reinforcing structure 50 may be distributed in front of, behind, to the left of, and to the right of, the first region 3051, respectively.

In embodiments of this disclosure, a joint effect served by the plurality of reinforcing structures 50 allows to improve the stiffness of the chip packaging structure effectively. In addition, the plurality of reinforcing structures 50 may distributed symmetrically with respect to the first region 3051, which facilitates guaranteeing overall uniformity of a force applied to the chip packaging structure.

In some optional examples, the heat dissipating cover 30 and the reinforcing structure 50 may be integrally formed. For example, the heat dissipating cover 30 and the reinforcing structure 50 may be integrally cut and formed. In this way, the heat dissipating cover 30 and the reinforcing structure 50 are simple to make, with a low processing cost. Of course, the heat dissipating cover 30 and the reinforcing structure 50 may also be molded respectively, and then firmly connected together by welding or in another way.

In some optional examples, the heat dissipating cover 30 may be made of copper. For example, the heat dissipating cover 30 may be made of red copper (i.e. pure copper) or brass (i.e. copper alloy). Understandably, copper is of good heat dissipation performance. In this way, a heat dissipating cover 30 made of copper facilitates guaranteeing the heat dissipation performance of the chip packaging structure.

In some optional examples, the heat dissipating cover 30 may be a cover structure plated with an anti-oxidation layer. For example, the heat dissipating cover 30 may be a cover structure plated with a nickel layer. A thickness of the nickel layer may be around 2 micrometers to 9 micrometers. For example, the thickness of the nickel layer may be 2 micrometers, 3 micrometers, 6 micrometers, 7 micrometers, 9 micrometers, etc., which are not listed one by one here. Providing the anti-oxidation layer may prevent oxidation corrosion of the heat dissipating cover 30, which facilitates improving a service life of the heat dissipating cover 30.

In some optional examples, at least two heat-generating chips 10 are located within the same accommodating space. For example, two, three or more heat-generating chips 10 may be accommodated within the same accommodating space. In this way, different heat-generating chips 10 may share the same heat dissipating cover 30 and the same reinforcing structure 50, which facilitates saving material and reducing a manufacturing cost. Of course, it is also possible that just one heat-generating chip 10 is accommodated within the same accommodating space.

In some optional examples, the chip packaging structure may be manufactured using a technological process as follows.
(1) The heat-generating chip 10 and the substrate 20 are interconnected by flip chip bonding technology. For example, the micro bumps 102 provided at the lower end of the heat-generating chip 10 may be welded to the substrate 20, to interconnect the heat-generating chip 10 and the substrate 20.
(2) The heat-generating chip 10 and the substrate 20 that are interconnected may be baked at 125 degrees Celsius for 1~2 hours, and then undergo plasma cleaning.
(3) A gap between the lower end of the heat-generating chip 10 and the substrate 20 may be filled with underfill adhesive through a dispensing process. Another 1~2 hours of baking at 125 degrees Celsius may be performed to cure the underfill adhesive.
(4) The upper surface of the heat-generating chip 10 may be coated with the thermal conductive medium 40 through a dispensing process. An edge of the upper surface of the substrate 20 may be coated with the adhesive 70. Then, the heat dissipating cover 30 and the reinforcing structure 50 that are integrally formed are placed upside down on top of the substrate 20. Then, 1~2 hours of baking at 150 degrees Celsius may be performed to cure the adhesive 70.

Optionally, the heat-generating chip 10 may be 18 millimeters in length, 16 millimeters in width, and 0.775 millimeters in thickness. The substrate 20 may be each may be 37.5 millimeters in both length and width, and 1.3175 millimeters in thickness. The thermal conductive medium 40 may be 100 micrometers in thickness. The heat spreader 308 included in the heat dissipating cover 30 may be 1 millimeters in thickness. The second surface 501 of the reinforcing structure 50 may be a flat surface or a curved surface. In case the second surface 501 is a flat surface as shown in FIG. 1 and FIG. 2, the reinforcing structure 50 may also be referred to as a triangular enhancement structure. In case the second surface 501 is a curved surface as shown in FIG. 3 and FIG. 4, the reinforcing structure 50 may also be referred to as a round-chamfer enhancement structure.

The inventor discovers, through finite element simulation, that during a stress test, in case of a test stress of 876 newton (N), one may refer to a curve 910 in FIG. 9 for case of stress deformation of a standard heat spreader in related art, and to a curve 920 in FIG. 9 for case of stress deformation of the heat spreader 308 included in the heat dissipating cover 30 in embodiments of this disclosure. A horizontal axis in FIG. 9 denotes locations along a surface diagonal of the heat spreader, and a vertical axis in FIG. 9 denotes amounts of stress deformation. Observation of FIG. 9 shows a maximal amount of deformation of 70 micrometers of the standard heat spreader in related art, and a maximal amount of deformation of 43 micrometers of the heat spreader 308 included in the heat dissipating cover 30 in embodiments of this disclosure. Clearly, anti-stress ability of the heat spreader 308 improves by 38% compared to the standard heat spreader, which therefore facilitates reducing amounts of deformation from which the heat spreader 308 and the thermal conductive medium 40 are to recover after the stress has been taken off, thereby mitigating the degree of separation of the heat spreader 308 and the thermal conductive medium 40.

The inventor further discovers, through finite element simulation, that warpage of the substrate in related art is 108 micrometers and 50 micrometers at 25 degrees Celsius and 260 degrees Celsius, respectively, and warpage of the substrate 20 in embodiments of this disclosure is 101 micrometers and 47 micrometers at 25 degrees Celsius and 260 degrees Celsius, respectively. Clearly, warpage of the substrate 20 is reduced by 6% compared to the substrate in related art, which facilitates mitigating the degree of separation of the heat spreader 308 and the thermal conductive medium 40.

To sum up, embodiments of this disclosure allow to improve the stiffness of the chip packaging structure, solve the problem of separation of the heat dissipating cover 30 and the thermal conductive medium 40, thereby improving the efficiency of heat conduction, guaranteeing the heat dissipation performance of the chip packaging structure.

Embodiments of this disclosure further provide a domain controller, including the chip packaging structure in any one foregoing embodiment. Refer to foregoing introduction for specific implementation of the chip packaging structure. Since the chip packaging structure has the foregoing technological effects, the domain controller including the chip packaging structure also has the respective technological effects, which are not repeated here.

Note that various optional embodiments and optional implementations disclosed above may be selected and combined flexibly as needed to implement the respective functions and effects, which are not enumerated in this disclosure.

Basic principles of this disclosure are described above in combination with specific embodiments. However, advantages, superiorities, and effects mentioned in this disclosure are merely examples but are not for limitation, and it cannot be considered that these advantages, superiorities, and effects are necessary for each embodiment of this disclosure. Specific details described above are merely for examples and for ease of understanding, rather than limitations. The details described above do not limit that this disclosure must be implemented by using the foregoing specific details.

Each embodiment in the specification is described progressively. Each embodiment stresses a difference from other embodiments. Refer to one embodiment for a same or similar portion in another embodiment.

A person skilled in the art may make various modifications and variations to this disclosure without departing from the spirit and the scope of this application. In this way, if these modifications and variations of this application fall within the scope of the claims of this disclosure and equivalent technologies of the claims, this disclosure also intends to include these modifications and variations.

## Claims

1. A chip packaging structure, **characterized in that** the chip packaging structure comprises:
a heat-generating chip (10);
a substrate (20), the substrate (20) carrying the heat-generating chip (10);
a heat dissipating cover (30), the heat dissipating cover (30) covering the substrate (20) such that the heat-generating chip (10) is located within an accommodating space enclosed by the substrate (20), an inner bottom wall (305) of the heat dissipating cover (30), and an inner side wall (307) of the heat dissipating cover (30);
a thermal conductive medium (40), the thermal conductive medium (40) being provided between a first surface (101) of the heat-generating chip (10) facing away from the substrate (20) and a first region (3051) of the inner bottom wall (305); and
a reinforcing structure (50), the reinforcing structure (50) abutting against a second region (3053) of the inner bottom wall (305) other than the first region (3051), the reinforcing structure (50) further abutting against the inner side wall (307), wherein a second surface (501) of the reinforcing structure (50) facing the heat-generating chip (10) meets that: the closer a part of the second surface (501) is to the inner side wall (307), the further it is away from the second region (3053) in distance, and the further the part is away from the inner side wall (307), the closer it is to the second region (3053) in distance.

2. The chip packaging structure according to claim 1, further comprising:
an electronic component (60), the substrate (20) carrying the electronic component (60), there being a gap between the electronic component (60) and the reinforcing structure (50).

3. The chip packaging structure according to claim 2, wherein the second surface (501) is a flat surface, and a slope of the flat surface is adapted to a structural parameter of the electronic component (60) and a layout of the electronic component (60) with respect to the substrate (20), to allow the gap between the electronic component (60) and the reinforcing structure (50).

4. The chip packaging structure according to claim 2, wherein the second surface (501) is a curved surface, and a curvature of the curved surface is adapted to a structural parameter of the electronic component (60) and a layout of the electronic component (60) with respect to the substrate (20), to allow the gap between the electronic component (60) and the reinforcing structure (50).

5. The chip packaging structure according to claim 2, wherein the reinforcing structure (50) is a solid structure, the reinforcing structure (50) is provided with a weight reducing groove (505) having a notch located at the second surface (501), the weight reducing groove (505) is provided on the reinforcing structure (50) at a providing location corresponding to a providing location at which the electronic component (60) is provided on the substrate (20), and a portion of the electronic component (60) extends into the weight reducing groove (505), and leaves a gap between the portion extending into the weight reducing groove (505) and an inner wall of the weight reducing groove (505).

6. The chip packaging structure according to claim 5, wherein one or more reinforcing structures (50) is distributed in front of, behind, to the left of, and to the right of, the first region (3051), respectively.

7. The chip packaging structure according to claim 2, wherein the reinforcing structure (50) is a hollow structure and the reinforcing structure (50) is a reinforcing plate placed at an angle, one end of the reinforcing plate is provided against the second region (3053) and the other end of the reinforcing plate is provided against the inner side wall 307, and an outer surface of the reinforcing plate may serve as the second surface (501).

8. The chip packaging structure according to claim 7, wherein one reinforcing structure (50) is distributed in front of, behind, to the left of, and to the right of, the first region (3051), respectively.

9. The chip packaging structure according to claim 1, wherein there is a gap between the reinforcing structure (50) and the thermal conductive medium (40), and there is a gap between the reinforcing structure (50) and the heat-generating chip (10).

10. The chip packaging structure according to claim 1, wherein the heat dissipating cover (30) is a cover structure functioning to conduct heat, for support, and to assist in forming the accommodating space, comprising:
a heat spreader (308), comprising an upper surface and a lower surface provided in parallel; and
a base (309), extending from the lower surface of the heat spreader (308) in a direction away from the upper surface of the heat spreader (308), and have a central through hole (3092), which may be a square hole, and a hole bottom wall of the central through hole (3092) and the lower surface of the heat spreader (308) are flush.

11. The chip packaging structure according to any one of claims 1-10,
wherein the height of the projection of the reinforcing structure (50) onto the inner side wall (307) is less than or equal to the height of the inner side wall (307), and/or
wherein a plurality of the reinforcing structure (50) are provided, and the plurality of reinforcing structures (50) are symmetrically distributed with respect to the first region (3051).

12. The chip packaging structure according to any one of claims 1-10,
wherein the heat dissipating cover (30) and the reinforcing structure (50) are integrally formed, and/or
wherein the heat dissipating cover (30) is made of copper, and/or
wherein the heat dissipating cover (30) is a cover structure plated with an anti-oxidation layer.

13. The chip packaging structure according to any one of claims 1-10, wherein at least two heat-generating chips (10) are located within the same accommodating space.

14. The chip packaging structure according to any one of claims 1-13, wherein the chip packaging structure is manufactured using a technological process as follows:
the heat-generating chip (10) and the substrate (20) are interconnected by flip chip bonding technology;
the heat-generating chip (10) and the substrate (20) that are interconnected are baked at 125 degrees Celsius for 1~2 hours, and then undergo plasma cleaning;
a gap between the lower end of the heat-generating chip (10) and the substrate (20) are filled with underfill adhesive through a dispensing process, another 1~2 hours of baking at 125 degrees Celsius is performed to cure the underfill adhesive;
the upper surface of the heat-generating chip (10) is coated with the thermal conductive medium (40) through a dispensing process, an edge of the upper surface of the substrate (20) is coated with the adhesive (70), then the heat dissipating cover (30) and the reinforcing structure (50) that are integrally formed are placed upside down on top of the substrate (20), and then 1~2 hours of baking at 150 degrees Celsius is performed to cure the adhesive 70.

15. A domain controller, **characterized in that** the domain controller comprises the chip packaging structure according to any one of claims 1-14.
